# EUROPÄISCHE PATENTANMELDUNG

(11) **EP 4 456 406 A1**
(43) Veröffentlichungstag der Anmeldung: **30.10.2024**
(21) Anmeldenummer: 24165714.7
(22) Anmeldetag: 22.03.2024
(51) Int. Cl.: H02M 7/5387, H02M 1/32, H02M 1/08, H02M 1/00, H03K 17/08, H03K 17/0812, H03K 17/18, G01R 31/14, G01R 31/26, G06F 11/30, G06N 3/02

(54) **VERFAHREN ZUM BETREIBEN EINES UMRICHTERS UND UMRICHTERANORDNUNG**

(30) Priorität: 24.04.2023 DE 102023203760
(71) Anmelder: VOLKSWAGEN AG, 38440 Wolfsburg (DE)
(72) Erfinder: Kube, Adrian, 91097 Oberreichenbach (DE)

(57) **Zusammenfassung**

Die Erfindung betrifft ein Verfahren zum Betreiben eines Umrichters (2), wobei Leistungshalbleiter des Umrichters (2) auf das Vorliegen von Entsättigungsfehlern überwacht werden, wobei bei Feststellen eines Entsättigungsfehlers bei mindestens einem der Leistungshalbleiter erfasste Zustandsdaten (10) des Umrichters (2) in einem nichtflüchtigen Speicher (6) abgelegt werden, wobei die erfassten Zustandsdaten (10) einem Expertensystem (20) zugeführt werden, welches dazu eingerichtet ist, ausgehend von den erfassten Zustandsdaten (10) mindestens eine Fehlerursache (21-x) zu bestimmen, wobei ein Ergebnis (21) des Expertensystems (20) in dem nichtflüchtigen Speicher (6) abgelegt wird. Ferner betrifft die Erfindung eine Umrichteranordnung (1).

## Beschreibung

Die Erfindung betrifft ein Verfahren zum Betreiben eines Umrichters und eine Umrichteranordnung.

Umrichter, beispielsweise Wechselrichter, verwenden Leistungshalbleiterschalter, z. B. Bipolartransistoren mit isoliertem Gate (IGBTs) oder MOSFETs, um beispielsweise elektrische Hochspannungs-Gleichstromleistung in Hochspannungs-Wechselstromleistung umzuwandeln, die an einen Elektromotor/Generator übertragen wird, um beispielsweise ein Drehmoment für die Traktionskraft in Fahrzeugen zu erzeugen.

Fehler im Zusammenhang mit Leistungshalbleiterschaltern und Wicklungen des Elektromotors/Generators können zu einem übermäßigen elektrischen Stromfluss durch die verschiedenen Komponenten und zu einer erhöhten Spannung über einem Kollektor und Emitter von einem oder mehreren der Leistungshalbleiterschalter führen, was als Entsättigung bezeichnet wird.

Bekannte Leistungshalbleiterschalter werden entweder in einen EIN-Zustand oder in einen AUS-Zustand gesteuert. Im EIN-Zustand mit bestimmungsgemäß funktionierendem Leistungshalbleiterschalter ist der elektrische Strom durch den Leistungshalbleiterschalter gesättigt, d. h. der gesamte verfügbare Strom fließt durch den Schalter, wobei ein kleiner Teil aufgrund des Schalterwiderstands in Wärmeenergie umgewandelt wird. Im AUS-Zustand blockiert der Schalter den elektrischen Stromfluss.

Ein Entsättigungsfehler in einem Leistungshalbleiterschalter kann dazu führen, dass der elektrische Strom über eine maximale Betriebsgrenze hinaus ansteigt, wobei der Leistungshalbleiterschalter in einen linearen Modus eintritt, wodurch der Leistungshalbleiterschalter entsättigt wird (engl. desaturation, abgekürzt als DSAT oder auch DESAT). Von einem DSAT-Zustand spricht man, wenn die Spannungsgröße über Kollektor und Emitter eines Leistungshalbleiterschalters über einen Schwellenwert ansteigt, z. B. 1-2 Volt, wenn eine Gate-Emitter-Spannung hochgesetzt ist. Bekannte Reaktionen auf einen DSAT-Fehler umfassen ein sofortiges Abschalten des Elektromotors/Generators. Bekannte Systeme sind derart konfiguriert, dass sie Kollektor-Emitter-Spannungen von Leistungshalbleiterschaltern überwachen, um DSAT-Fehler zu erkennen, und umfassen Steuersysteme, um ein sofortiges Abschalten des Elektromotors/Generators bei Erkennung eines DSAT-Fehlers zu bewirken.

Um festzustellen, was die konkrete Ursache des DSAT-Fehlers ist, muss bisher immer eine Analyse auf System-, Hardware- und Softwareebene durchgeführt werden. Meist wird eine Fehlerursachenanalyse anhand eines Ishikawa-Diagramms durchgeführt. Diese Analysen sind sehr aufwändig und kostenintensiv. Oft sind Nachmessungen nötig, weil ein genauer Zustand des Systems zum Ausfallzeitpunkt nicht bekannt ist.

Der Erfindung liegt die Aufgabe zu Grunde, ein Verfahren zum Betreiben eines Umrichters und eine Umrichteranordnung zu schaffen, mit denen insbesondere eine Fehlerursachenanalyse nach dem Auftreten eines DSAT-Fehler vereinfacht werden kann.

Die Aufgabe wird erfindungsgemäß durch ein Verfahren mit den Merkmalen des Patentanspruchs 1 und eine Umrichteranordnung mit den Merkmalen des Patentanspruchs 10 gelöst. Vorteilhafte Ausgestaltungen der Erfindung ergeben sich aus den Unteransprüchen.

Insbesondere wird ein Verfahren zum Betreiben eines Umrichters zur Verfügung gestellt, wobei Leistungshalbleiterschalter des Umrichters auf das Vorliegen von Entsättigungsfehlern überwacht werden, wobei bei Feststellen eines Entsättigungsfehlers bei mindestens einem der Leistungshalbleiterschalter erfasste Zustandsdaten des Umrichters, insbesondere vor einem Auslösen von Maßnahmen, in einem nichtflüchtigen Speicher abgelegt werden, wobei die erfassten Zustandsdaten einem Expertensystem zugeführt werden, welches dazu eingerichtet ist, ausgehend von den erfassten Zustandsdaten mindestens eine Fehlerursache zu bestimmen, wobei ein Ergebnis des Expertensystems in dem nichtflüchtigen Speicher abgelegt wird.

Ferner wird insbesondere eine Umrichteranordnung geschaffen, umfassend einen Umrichter, und eine Steuereinrichtung, wobei die Steuereinrichtung dazu eingerichtet ist, Leistungshalbleiterschalter des Umrichters auf das Vorliegen von Entsättigungsfehlern zu überwachen, und bei Feststellen eines Entsättigungsfehlers bei mindestens einem der Leistungshalbleiterschalter erfasste Zustandsdaten des Umrichters, insbesondere vor einem Auslösen von Maßnahmen, in einem nichtflüchtigen Speicher abzulegen, ferner ein Expertensystem bereitzustellen, welches dazu eingerichtet ist, ausgehend von den erfassten Zustandsdaten mindestens eine Fehlerursache zu bestimmen, die erfassten Zustandsdaten dem Expertensystem zuzuführen, und ein Ergebnis des Expertensystems in dem nichtflüchtigen Speicher abzulegen.

Das Verfahren und die Umrichteranordnung ermöglichen es, beim Auftreten eines Entsättigungsfehlers, zum einen, erfasste Zustandsdaten des Umrichters für eine spätere Fehlerursachenanalyse nichtflüchtig abzuspeichern und, zum anderen, bereits eine erste Fehlerursachenanalyse durchzuführen und die hierbei erhaltenen Ergebnisse ebenfalls nichtflüchtig abzuspeichern. Dies vereinfacht eine Fehlerursachenanalyse, da die Zustandsdaten bei Auftreten des Entsättigungsfehlers festgehalten werden und ferner bereits bekannte Fehlerursachen abgeprüft worden sind. Hierzu ist vorgesehen, dass bei Feststellen eines Entsättigungsfehlers bei mindestens einem der Leistungshalbleiterschalter erfasste Zustandsdaten des Umrichters vor einem Auslösen von Maßnahmen (wie z.B. einem Überführen des Umrichters in einen sicheren Zustand, beispielsweise durch Abschalten) in einem nichtflüchtigen Speicher abgelegt werden. Ferner werden die erfassten Zustandsdaten einem Expertensystem zugeführt. Das Expertensystem ist dazu eingerichtet, ausgehend von den erfassten Zustandsdaten mindestens eine Fehlerursache zu bestimmen, wobei ein Ergebnis des Expertensystems ebenfalls in dem nichtflüchtigen Speicher abgelegt wird.

Ein Vorteil des Systems ist, dass die Verfahrensschritte direkt nach dem Feststellen des Entsättigungsfehlers durchgeführt werden können. Sollte ein Entsättigungsfehler derart gravierende Folgen haben, dass ein Teil einer Leistungselektronik des Umrichters hierdurch zerstört wird, so können dennoch, gegebenenfalls unvollständige, Daten bereitgestellt werden, die die Fehlerursachenanalyse unterstützen.

Der nichtflüchtige Speicher ist insbesondere ein Flash-Speicher (insbesondere Flash-EEPROM) oder ein nichtflüchtiger RAM (engl. non-volatile Random-Access Memory, NVRAM).

Die erfassten Zustandsdaten können zumindest eine der folgenden umfassen: Phasenspannungen, Phasenströme, eine Hochvolt-Gleichspannung, eine Niedervolt-Gleichspannung, eine Zwischenkreisspannung, eine Gatetreiber-Versorgungsspannung, eine Ansteuerversorgungsspannung, eine Platinen-Temperatur, eine Gatetreiber-IC-Temperatur, Werte von auslesbaren Gatetreiber-IC-Registern, eine Leistungsmodul-Temperatur, Thermomodell-Temperaturen, einen Isolationswächterstatus, eine Softwareversion, eine Parameterwertversion.

Das Expertensystem ist insbesondere in einem Speicher, beispielsweise einem Arbeitsspeicher oder dem nichtflüchtigen Speicher, hinterlegt. Das Expertensystem umfasst insbesondere eine Zuordnung von Zuständen des Umrichters, welche durch die Zustandsdaten repräsentiert sind, zu einer oder zu mehreren Fehlerursachen. Das Expertensystem kann beispielsweise als Regelsystem und/oder mathematische Funktion und/oder Abbildung ausgestaltet sein. Das Expertensystem kann beispielsweise ausgehend von empirischen Versuchsreihen, Feldversuchen und/oder im normalen Betrieb gesammelten Daten aus dem Feld erzeugt werden. Grundsätzlich können zusätzlich oder alternativ auch Simulationen zum Erzeugen des Expertensystems verwendet werden. Ferner kann das Expertensystem auch Verfahren der Künstlichen Intelligenz, insbesondere Maschinenlernverfahren, verwenden.

Teile der Umrichteranordnung, insbesondere die Steuereinrichtung, können einzeln oder zusammengefasst als eine Kombination von Hardware und Software ausgebildet sein, beispielsweise als Programmcode, der auf einem Mikrocontroller oder Mikroprozessor ausgeführt wird. Es kann jedoch auch vorgesehen sein, dass Teile einzeln oder zusammengefasst als anwendungsspezifische integrierte Schaltung (ASIC) und/oder feldprogrammierbares Gatterfeld (FPGA) ausgebildet sind.

Der Begriff Umrichter umfasst insbesondere Wechselrichter, Gleichrichter, Gleichspannungswandler und Wechselspannungswandler.

Das Verfahren und die Umrichteranordnung lassen sich auf sämtlichen Gebieten einsetzen, bei denen Umrichter zum Einsatz kommen. Beispielsweise in Elektro- oder Hybridfahrzeugen, im Zusammenhang mit Solar- oder Windkraftanlagen und im Bereich von Industrieumrichtern.

In einer Ausführungsform ist vorgesehen, dass Werte zumindest eines Teils der erfassten Zustandsdaten sofort nach Feststellen des Entsättigungsfehlers zum Speichern verriegelt ("gelatched") werden. Hierdurch kann verhindert werden, dass geänderte Werte abgespeichert werden, wenn durch Auslösen und Einleiten von Maßnahmen, beispielsweise einem Abschalten des Umrichters und/oder einer von diesem gespeisten elektrischen Maschine, Zustandsdaten des Umrichters verändert werden. Hingegen kann erreicht werden, dass diejenigen Zustandsdaten in dem nichtflüchtigen Speicher abgelegt werden, die beim Auftreten des Entsättigungsfehlers vorlagen.

In einer Ausführungsform ist vorgesehen, dass das Ablegen der erfassten Zustandsdaten in dem nichtflüchtigen Speicher mit höchster Priorität erfolgt. Hierdurch kann insbesondere erreicht werden, dass ein Speichern der erfassten Zustandsdaten noch erfolgt, bevor der Umrichter und andere Komponenten gegebenenfalls zerstört werden und ein Speichern dann nicht mehr möglich ist. Selbst wenn durch den Entsättigungsfehler größere Schäden verursacht werden, können zumindest so viele Zustandsdaten wie möglich noch in dem nichtflüchtigen Speicher abgelegt werden, sodass eine Fehlerursachenanalyse noch unterstützt werden kann.

In einer Ausführungsform ist vorgesehen, dass das Ergebnis des Expertensystems in dem nichtflüchtigen Speicher in Form eines Bitfeldes kodiert wird. Hierdurch kann eine Information zu möglichen Fehlerursachen auf besonders einfache und übersichtliche Weise bereitgestellt werden. Die Fehlerursachen können dann als Zahlen mittels des Bitfeldes kodiert werden, sodass Fehlercodes bereitgestellt werden können, welche mit einem oder mehreren Fehlerursachen korrespondieren.

In einer Ausführungsform ist weiterbildend vorgesehen, dass jedem Bit in dem Bitfeld eine Fehlerursache zugeordnet ist. In diesem einfachen Fall entspricht jedes Bit in dem Bitfeld einer Fehlerursache. Die Ausprägung des jeweiligen Bits im Ergebnis des Expertensystems kodiert dann das Vorliegen (z.B. "1") oder Nichtvorliegen (z.B. "0") der hiermit verknüpften Fehlerursache.

In einer Ausführungsform ist vorgesehen, dass beim Starten des Umrichters ein Starttest durchgeführt wird, wobei der Starttest zumindest ein Überprüfen einer Versorgungsspannung und/oder ein Überprüfen von Spannungssignalen an Gatetreibern des Umrichters und/oder ein Überprüfen von Schaltvorgängen von Gates des Umrichters und/oder ein Überprüfen einer sich jeweils ergebenen Phasenspannung umfasst, wobei ein Überprüfungsergebnis in dem nichtflüchtigen Speicher abgelegt wird. Hierdurch kann eine Zuverlässigkeit des Umrichters erhöht werden. Ferner können hierdurch weitere Daten für eine spätere Fehlerursachenanalyse bereitgestellt werden.

In einer Ausführungsform ist vorgesehen, dass das Ablegen der erfassten Zustandsdaten und/oder das Bestimmen der Fehlerursache mittels des Expertensystems mittels einer zumindest für diese Zeit reservierten Recheneinrichtung durchgeführt wird. Hierdurch kann sichergestellt werden, dass das Ablegen der erfassten Zustandsdaten und/oder das Bestimmen der Fehlerursache noch erfolgen können, bevor ein Betrieb des Umrichters bzw. der Umrichteranordnung nicht mehr möglich ist. Ist die Steuereinrichtung der Umrichteranordnung beispielsweise Teil eines Antriebsstrangs eines Elektrofahrzeugs und weist mehrere Recheneinrichtungen auf, so kann eine der Recheneinrichtungen ausschließlich für das Ablegen der erfassten Zustandsdaten und/oder das Bestimmen der Fehlerursache mittels des Expertensystems verwendet werden, eine oder mehrere andere Recheneinrichtungen der Steuereinrichtung hingegen für das Einleiten und/oder Steuern von Maßnahmen, welche den Umrichter und/oder das Elektrofahrzeug in einen sicheren Zustand überführen. Die separate Recheneinrichtung stellt sicher, dass möglichst viele der erfassten Zustandsdaten noch abgespeichert werden können und/oder das Ergebnis des Expertensystems noch bestimmt und abgespeichert werden kann.

In einer Ausführungsform ist vorgesehen, dass ausgehend von dem Ergebnis des Expertensystems fehlerabhängig mindestens ein Zähler erhöht oder verringert wird. Hierdurch kann eine Abstufung von Fehlern gemäß ihrer Häufigkeit berücksichtigt werden.

In einer Ausführungsform ist vorgesehen, dass ausgehend von dem Ergebnis des Expertensystems und/oder eines Zählerstandes des mindestens einen Zählers mindestens eine Maßnahme zur Fehlerbehebung eingeleitet wird. Hierdurch können weniger kritische Fehler vorerst ignoriert werden und/oder Maßnahmen in Abhängigkeit von einem Zählerstand des mindestens einen Zählers ausgewählt und/oder ausgelöst werden, um beispielsweise zu versuchen, den Fehler bzw. die Fehlerursache zu beheben. Wird beispielsweise eine Überhitzung eines Leistungsmoduls des Umrichters als Fehlerursache festgestellt, so wird der Zähler um eins erhöht (oder vermindert, je nach konkreter Ausgestaltung des Zählers). Anschließend kann der Umrichter ausgeschaltet werden, beispielsweise kann, sofern dies zu einem aktuellen Zeitpunkt möglich ist, eine Zündung eines Elektrofahrzeugs ausgeschaltet werden und nach kurzer Wartezeit, in der das Leistungsmodul abkühlen kann, wieder eingeschaltet werden. Anschließend kann das Verfahren erneut durchgeführt werden. Wenn der Zähler einen vorgegebenen Zählerstand für die vorgenannte beispielhafte Fehlerursache erreicht hat, wird der Umrichter beispielsweise endgültig abgeschaltet und ein Wiedereinschalten blockiert.

Weitere Merkmale zur Ausgestaltung der Umrichteranordnung ergeben sich aus der Beschreibung von Ausgestaltungen des Verfahrens. Die Vorteile der Umrichteranordnung sind hierbei jeweils die gleichen wie bei den Ausgestaltungen des Verfahrens.

Ferner wird insbesondere auch ein Fahrzeug geschaffen, umfassend mindestens eine Umrichteranordnung nach einer der beschriebenen Ausführungsformen. Ein Fahrzeug ist insbesondere ein Kraftfahrzeug, insbesondere ein Elektrofahrzeug oder ein Hybridfahrzeug. Grundsätzlich kann das Fahrzeug aber auch ein anderes Land-, Schienen-, Wasser-, Luft- oder Raumfahrzeug sein, beispielsweise ein Lufttaxi oder eine Drohne.

Nachfolgend wird die Erfindung anhand bevorzugter Ausführungsbeispiele unter Bezugnahme auf die Figur näher erläutert. Hierbei zeigt:

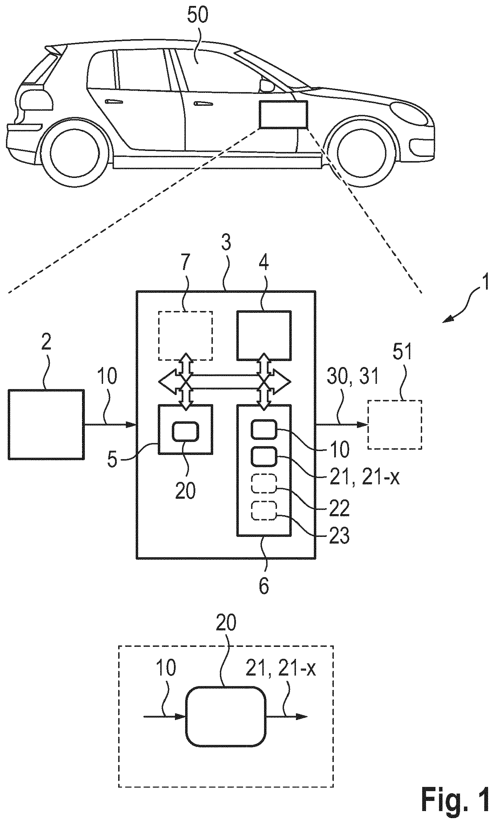

- Fig. 1: eine schematische Darstellung von Ausführungsformen der Umrichteranordnung.

Die Fig. 1 zeigt eine schematische Darstellung von Ausführungsformen der Umrichteranordnung 1. Die Umrichteranordnung 1 ist insbesondere in einem Fahrzeug 50, insbesondere einem Elektrofahrzeug, angeordnet und bildet dort beispielsweise einen Teil eines Traktionsstrangs. Die Umrichteranordnung 1 ist dazu eingerichtet, das in dieser Offenbarung beschriebene Verfahren auszuführen. Das in dieser Offenbarung beschriebene Verfahren wird nachfolgend anhand der Umrichteranordnung 1 näher erläutert.

Die Umrichteranordnung 1 umfasst einen Umrichter 2 und eine Steuereinrichtung 3. Die Steuereinrichtung 3 kann grundsätzlich auch Teil des Umrichters 2 sein oder den Umrichter 2 steuern und/oder regeln. Der Umrichter 2 ist beispielsweise ein Pulswechselrichter, der zum Speisen einer mehrphasigen elektrischen Maschine des Fahrzeugs 50 dient. Die Steuereinrichtung 3 umfasst beispielsweise eine Recheneinrichtung 4 und einen Speicher 5. Ferner umfasst die Steuereinrichtung 3 einen nichtflüchtigen Speicher 6, beispielsweise einen Flash-Speicher oder einen nichtflüchtigen RAM-Speicher (NVRAM).

Die Steuereinrichtung 3 ist dazu eingerichtet ist, Leistungshalbleiterschalter (z.B. IGBTs oder MOSFETs) des Umrichters 2 auf das Vorliegen von Entsättigungsfehlern zu überwachen und bei Feststellen eines Entsättigungsfehlers bei mindestens einem der Leistungshalbleiterschalter erfasste Zustandsdaten 10 des Umrichters 2, insbesondere vor einem Auslösen von Maßnahmen, in dem nichtflüchtigen Speicher 4 abzulegen. Das Überwachen der Leistungshalbleiterschalter erfolgt in an sich bekannter Weise. Ferner ist die Steuereinrichtung 3 dazu eingerichtet, ein Expertensystem 20 bereitzustellen, beispielsweise wird das Expertensystem 20 in Form von Beschreibungsdaten in dem Speicher 5 abgelegt und kann von dort von der Recheneinrichtung 4 abgerufen und angewandt werden. Das Expertensystem 20 ist dazu eingerichtet, ausgehend von den erfassten Zustandsdaten 10 mindestens eine Fehlerursache 21-x zu bestimmen. Die erfassten Zustandsdaten 10 werden hierzu dem Expertensystem 20 zugeführt. Ein Ergebnis 21 des Expertensystems 20 wird von der Steuereinrichtung 3 in dem nichtflüchtigen Speicher 6 abgelegt.

Es ist insbesondere vorgesehen, dass Werte zumindest eines Teils der erfassten Zustandsdaten 10 sofort nach Feststellen des Entsättigungsfehler zum Speichern verriegelt ("gelatched") werden. Insbesondere werden die Werte der erfassten Zustandsdaten 10, die beim Feststellen des Entsättigungsfehlers vorlagen, gespeichert, sodass diese Werte für eine Fehlerursachenanalyse zur Verfügung stehen. Es kann auch vorgesehen sein, auf historische Werte zurückzugreifen und einen oder mehrere historische Werte der erfassten Zustandsdaten 10 abzuspeichern, beispielsweise Werte die unmittelbar vor und beim Auftreten des Entsättigungsfehlers erfasst wurden. Hierdurch kann die Fehlerursachenanalyse noch besser unterstützt werden.

Es ist insbesondere vorgesehen, dass das Ablegen der erfassten Zustandsdaten 10 in dem nichtflüchtigen Speicher 6 mit höchster Priorität erfolgt. Insbesondere werden in der Recheneinrichtung 4 hierfür vorgesehene Rechenoperationen ("Tasks") mit höchster Priorität abgearbeitet.

Es kann vorgesehen sein, dass das Ergebnis 21 des Expertensystems 20 in dem nichtflüchtigen Speicher 6 in Form eines Bitfeldes kodiert wird.

Weiterbildend kann vorgesehen sein, dass jedem Bit in dem Bitfeld eine Fehlerursache 21-x zugeordnet ist. Beispielsweise kann das Bitfeld eine Größe von 32 oder 64 Bits aufweisen, wodurch insgesamt 32 bzw. 64 Fehlerursachen direkt angegeben werden können. Grundsätzlich ist auch eine andere Kodierung möglich, bei der die Bits nicht einer einzigen Fehlerursache 21-x entsprechen, sondern bei dem mittels der Bits kodierte Zahlen jeweils für einzelne Fehlerursachen 21-x oder Kombinationen von Fehlerursachen 21-x stehen.

Es kann vorgesehen sein, dass beim Starten des Umrichters 2 ein Starttest durchgeführt wird, wobei der Starttest zumindest ein Überprüfen einer Versorgungsspannung und/oder ein Überprüfen von Spannungssignalen an Gatetreibern des Umrichters 2 und/oder ein Überprüfen von Schaltvorgängen von Gates des Umrichters 2 und/oder ein Überprüfen einer sich jeweils ergebenen Phasenspannung umfasst, wobei ein Überprüfungsergebnis 22 in dem nichtflüchtigen Speicher 6 abgelegt wird. Das Überprüfen der Spannungen kann beispielsweise durch einen Vergleich mit minimalen und/oder maximalen Schwellwerten durchgeführt werden. Die Spannungssignale und/oder die Schaltvorgänge können beispielsweise durch Überprüfen einer vorgegebenen oder erwarteten Korrespondenz zwischen den Spannungssignalen und den jeweiligen Schaltzuständen der Gatetreiber und Gates überprüft werden. Die Phasenspannungen können beispielsweise mit aus den Schaltzuständen der Gates abgeleiteten Werten verglichen werden, wobei eine auftretende Abweichung anhand von vorgegebenen Schwellwerten überprüft werden kann.

Es kann vorgesehen sein, dass das Ablegen der erfassten Zustandsdaten 10 und/oder das Bestimmen der Fehlerursache 21-x mittels des Expertensystems 20 mittels einer zumindest für diese Zeit reservierten Recheneinrichtung 7 durchgeführt wird.

Es kann vorgesehen sein, dass ausgehend von dem Ergebnis 21 des Expertensystems 20 fehlerabhängig mindestens ein Zähler 23 erhöht oder verringert wird. Beispielsweise können ein oder mehrere Zähler 23 für eine oder mehrere Fehlerursachen 21-x vorgesehen sein.

Insbesondere kann vorgesehen sein, dass ausgehend von dem Ergebnis 21 des Expertensystems 20 und/oder eines Zählerstandes des mindestens einen Zählers 23 mindestens eine Maßnahme 30 zur Fehlerbehebung eingeleitet wird. Hierzu kann insbesondere ein Maßnahmensignal 31 erzeugt und bereitgestellt werden, das beispielsweise einer Fahrzeugsteuerung 51 zugeführt wird. Es kann beispielsweise vorgesehen sein, dass einer Fehlerursache 21-x vom Typ "Überhitzung des Leistungsmoduls" ein Zähler 23 zugeordnet ist. Bei Auftreten dieser Fehlerursache 21-x wird der Zähler 23 beispielsweise um eins erhöht (oder umgekehrt um eins verringert, je nach konkreter Ausgestaltung). Nach Auftreten dieser Fehlerursache 21-x wird ferner mittels einer Maßnahme 30 versucht, den Fehler zu beheben. Beispielsweise wird in einem Elektrofahrzeug eine Zündung ausgeschaltet (nachdem das Elektrofahrzeug in einen sicheren Zustand überführt wurde), damit das überhitzte Leistungsmodul abkühlen kann. Nach einer vorgegebenen Wartezeit wird die Zündung wieder eingeschaltet und ein Weiterbetrieb des Elektrofahrzeugs ist möglich. Tritt dann erneut ein Entsättigungsfehler mit derselben Fehlerursache 21-x auf, so wird der zugehörige Zähler 23 erneut um eins erhöht (bzw. verringert) und die Maßnahme 30 wird erneut durchgeführt usw. Erreicht der Zählerstand des Zählers 23 jedoch einen Schwellwert, so wird als endgültige Maßnahme 30 beispielsweise eine vollständige Abschaltung durchgeführt (nachdem das Elektrofahrzeug in einen sicheren Zustand überführt wurde), wobei dann kein erneutes Starten mehr möglich ist und ein Werkstattbesuch notwendig ist.

### Bezugszeichenliste

- 1: Umrichteranordnung
- 2: Umrichter
- 3: Steuereinrichtung
- 4: Recheneinrichtung
- 5: Speicher
- 6: nichtflüchtiger Speicher
- 7: reservierte Recheneinrichtung
- 10: erfasste Zustandsdaten
- 20: Expertensystem
- 21: Ergebnis
- 21-x: Fehlerursache
- 22: Überprüfungsergebnis
- 23: Zähler
- 30: Maßnahme
- 31: Maßnahmensignal
- 50: Fahrzeug
- 51: Fahrzeugsteuerung

## Patentansprüche

1. Verfahren zum Betreiben eines Umrichters (2),
wobei Leistungshalbleiter des Umrichters (2) auf das Vorliegen von Entsättigungsfehlern überwacht werden,
wobei bei Feststellen eines Entsättigungsfehlers bei mindestens einem der Leistungshalbleiter erfasste Zustandsdaten (10) des Umrichters (2) in einem nichtflüchtigen Speicher (6) abgelegt werden,
wobei die erfassten Zustandsdaten (10) einem Expertensystem (20) zugeführt werden, welches dazu eingerichtet ist, ausgehend von den erfassten Zustandsdaten (10) mindestens eine Fehlerursache (21-x) zu bestimmen,
wobei ein Ergebnis (21) des Expertensystems (20) in dem nichtflüchtigen Speicher (6) abgelegt wird.

2. Verfahren nach Anspruch 1, **dadurch gekennzeichnet, dass** Werte zumindest eines Teils der erfassten Zustandsdaten (10) sofort nach Feststellen des Entsättigungsfehlers zum Speichern verriegelt werden.

3. Verfahren nach einem der vorangegangenen Ansprüche, **dadurch gekennzeichnet, dass** das Ablegen der erfassten Zustandsdaten (10) in dem nichtflüchtigen Speicher (6) mit höchster Priorität erfolgt.

4. Verfahren nach einem der vorangegangenen Ansprüche, **dadurch gekennzeichnet, dass** das Ergebnis (21) des Expertensystems (20) in dem nichtflüchtigen Speicher (6) in Form eines Bitfeldes kodiert wird.

5. Verfahren nach Anspruch 4, **dadurch gekennzeichnet, dass** jedem Bit in dem Bitfeld eine Fehlerursache (21-x) zugeordnet ist.

6. Verfahren nach einem der vorangegangenen Ansprüche, **dadurch gekennzeichnet, dass** beim Starten des Umrichters (2) ein Starttest durchgeführt wird, wobei der Starttest zumindest ein Überprüfen einer Versorgungsspannung und/oder ein Überprüfen von Spannungssignalen an Gatetreibern des Umrichters (2) und/oder ein Überprüfen von Schaltvorgängen von Gates des Umrichters (2) und/oder ein Überprüfen einer sich jeweils ergebenen Phasenspannung umfasst, wobei ein Überprüfungsergebnis (22) in dem nichtflüchtigen Speicher (6) abgelegt wird.

7. Verfahren nach einem der vorangegangenen Ansprüche, **dadurch gekennzeichnet, dass** das Ablegen der erfassten Zustandsdaten (10) und/oder das Bestimmen der Fehlerursache (21-x) mittels des Expertensystems (20) mittels einer zumindest für diese Zeit reservierten Recheneinrichtung (7) durchgeführt wird.

8. Verfahren nach einem der vorangegangenen Ansprüche, **dadurch gekennzeichnet, dass** ausgehend von dem Ergebnis (21) des Expertensystems (20) fehlerabhängig mindestens ein Zähler (23) erhöht oder verringert wird.

9. Verfahren nach einem der vorangegangenen Ansprüche, **dadurch gekennzeichnet, dass** ausgehend von dem Ergebnis (21) des Expertensystems (20) und/oder eines Zählerstandes des mindestens einen Zählers (23) mindestens eine Maßnahme zur Fehlerbehebung eingeleitet wird.

10. Umrichteranordnung (1), umfassend:
einen Umrichter (2), und
eine Steuereinrichtung (3),
wobei die Steuereinrichtung (3) dazu eingerichtet ist, Leistungshalbleiter des Umrichters (2) auf das Vorliegen von Entsättigungsfehlern zu überwachen, und
bei Feststellen eines Entsättigungsfehlers bei mindestens einem der Leistungshalbleiter erfasste Zustandsdaten (10) des Umrichters (2) in einem nichtflüchtigen Speicher (5) abzulegen,
ferner ein Expertensystem (20) bereitzustellen, welches dazu eingerichtet ist, ausgehend von den erfassten Zustandsdaten (10) mindestens eine Fehlerursache (21-x) zu bestimmen,
die erfassten Zustandsdaten (10) dem Expertensystem (20) zuzuführen, und
ein Ergebnis (21) des Expertensystems (20) in dem nichtflüchtigen Speicher (6) abzulegen.
